# EUROPÄISCHE PATENTSCHRIFT

(11) **EP 1 225 249 B1**
(45) Veröffentlichungstag und Bekanntmachung des Hinweises auf die Patenterteilung: **02.12.2009**
(21) Anmeldenummer: 01129511.0
(22) Anmeldetag: 11.12.2001
(51) Int. Cl.: C23C 14/34, H01J 37/34

(54) **Rohrförmiges Target und Verfahren zur Herstellung eines solchen Targets**
Tubular target and method for its production
Cible cylindrique et son procédé de fabrication

(30) Priorität: 19.01.2001 DE 10102493
(43) Veröffentlichungstag der Anmeldung: 24.07.2002
(73) Patentinhaber: W.C. Heraeus GmbH, 63450 Hanau (DE)
(72) Erfinder: Heck, Ralf, 63454 Hanau (DE); Lupton, David Francis, Dr., 63571 Gelnhausen (DE); Stenger, Bernd, 63546 Hammersbach (DE); Warkentin, Oliver, Dr., 64285 Darmstadt (DE)
(74) Vertreter: Kühn, Hans-Christian

(56) Entgegenhaltungen:
- EP-A- 0 500 031
- WO-A-97/15697
- US-A- 4 445 997
- PATENT ABSTRACTS OF JAPAN vol. 018, no. 296 (C-1209), 6. Juni 1994 (1994-06-06) -& JP 06 057419 A (MITSUBISHI MATERIALS CORP), 1. März 1994 (1994-03-01)

## Beschreibung

Die Erfindung betrifft ein rohrförmiges Target für eine Kathodenzerstäubungsanlage mit einem rohrförmigen Zerstäubungsmaterial und einem Trägerrohr, wobei das Zerstäubungsmaterial einen kreisringförmigen Querschnitt aufweist und einen Längenabschnitt des Trägerrohrs konzentrisch umgibt und wobei das Trägerrohr zum Anschluss an die Kathodenzerstäubungsanlage an mindestens einem der beiden Enden des Targets aus dem Zerstäubungsmaterial ragt. Die Erfindung betrifft des weiteren ein Verfahren zur Herstellung eines solchen Targets.

EP 0 500 031 B1 offenbart unterschiedliche Verfahren zur Herstellung eines rohrförmigen Sputtertargets beziehungsweise eines rohrförmigen Targets für die Kathodenzerstäubung. Dabei werden Targets mit einem durchgehendem Trägerrohr beschrieben, die vor allem für bruchanfällige oder weiche Zerstäubungsmaterialien wie Sn oder Si geeignet sind. Ein fest haftender Auftrag des Zerstäubungsmaterials auf das Trägerrohr durch Plasmaspritzen, Flammspritzen, Angießen in geschmolzenem Zustand, galvanische Abscheidung oder Heißpressen ist beschrieben.

EP 0 500 774 B1 beschreibt eine Sputtervorrichtung zur Beschichtung großer Flächen mit einem zylindrischen, hohlen Target in einer Vakuumkammer, wobei das Target in einer um seine Längsachse drehbaren Weise gehaltert ist. Innerhalb des hohlen Targets befindet sich eine Kühlmittelleitung sowie eine langgestreckte Magnetkonstruktion, die gegen ein Mitdrehen mit dem Target gesichert sind. Die Herstellung eines zylindrischen Targets ohne Trägerrohr durch Gießen von geschmolzenem Targetmaterial und von Targets mit einem Trägerrohr aus zum Beispiel Messing und einem Auftrag des Targetmaterials durch Plasmaspritzen oder Aufspritzen einer Flüssigkeit ist beschrieben. Das zylindrische Target wird an beiden Enden über jeweils eine Spindel mit einer Halterung verbunden.

Der Anschluss der Enden eines rohrförmigen Targets über solche Spindeln ist die am häufigsten angewandte Methode.

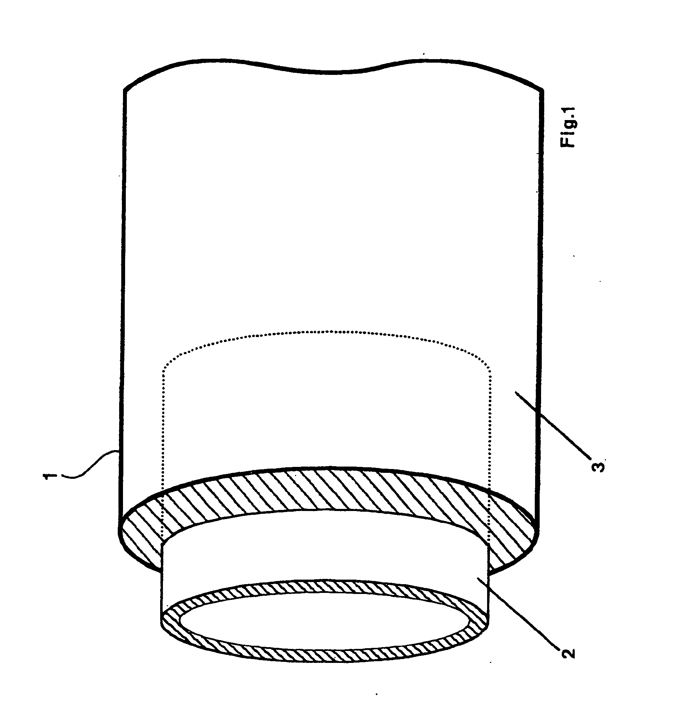

WO 97/15697 zeigt diese Anschlusstechnik zwischen einem rohrförmigen Target und einer Halterung in einer Kathodenzerstäubungsanlage im Detail in Figur 1. Das Trägerrohr eines Targets, oder bei mechanisch stabilen Zerstäubungsmaterialien auch das rohrförmige Zerstäubungsmaterial selbst, wird an einem Ende mit einer Spiralnut versehen, in die eine Feder eingelegt wird. Eine Spindel, die an der Kontaktfläche zum Trägerrohr oder dem Zerstäubungsmaterial einen Flansch aufweist und in diesem Flansch eine Nut mit einem O-Ring aufweist, wird stumpf auf das Ende des Trägerrohrs oder Zerstäubungsmaterials aufgesetzt und durch einen Spindelring mit dem Trägerrohr oder dem Zerstäubungsmaterial verschraubt. Nachteilig ist hier, dass insbesondere die Bearbeitung langer Trägerrohre zur Herstellung der Spiralnut im Anschlussbereich schwierig ist. Es erfordert einen hohen apparativen Aufwand, die im Hinblick auf eine gasdichte Verbindung geforderte Maßhaltigkeit an der Spiralnut zu erzielen.

US-4,445,997 offenbart ein rohrförmiges Target für eine Kathodenzerstäubungsanlage mit einem rohrförmigen Zerstäubungsmaterial und einem Trägerrohr, wobei das Zerstäubungsmaterial einen kreisringförmigen Querschnitt aufweist und einen Längenabschnitt des Trägerrohrs konzentrisch umgibt.
Das Trägerrohr weist einen Flansch an beiden Enden des Targets auf, der mit einer Stirnfläche des Zerstäubungsmaterials über mindestens zwei Schrauben mit dem rohrförmigen Zerstäubungsmaterial verbunden ist.

Rohrförmige Targets ohne Trägerrohr werden nun nach Gebrauch wegen des zum Teil sehr teuren Zerstäubungsmaterials üblicherweise dadurch recycelt, dass das Restmaterial aufgeschmolzen und wiederverwendet wird. Bei einem rohrförmigen Target mit einem Trägerrohr wird der Rest an Zerstäubungsmaterial von Trägerrohr beispielsweise durch Abdrehen entfernt und das Zerstäubungsmaterial in Form von Spänen eingeschmolzen und wiederverwendet. Das abgedrehte, saubere Trägerrohr wird ebenfalls wiederverwendet und neu mit Zerstäubungsmaterial beschichtet. Dies ist insbesondere aufgrund der großen Targetlängen von üblicherweise 2.5 bis 4m rentabel. Durch einen Transport des verbrauchten Targets oder die Recyclingmaßnahmen selbst kann nun bei den bisher bekannten, einteiligen Trägerrohren der Anschlussbereich des Trägerrohres so beschädigt werden, dass eine Wiederverwendung beziehungsweise ein erneutes Abdichten mit einer Spindel, wie oben beschrieben, nicht möglich ist. Nachteilig ist beim Recycling auch, dass die Trennung von Zerstäubungsmaterial und Trägerrohr meist durch eine teure, spanende Bearbeitung erfolgen muss.

Es stellt sich damit das Problem, ein rohrförmiges Target mit einem rohrförmigen Zerstäubungsmaterial und einem Trägerrohr bereitzustellen, das die Nachteile bekannter rohrförmiger Targets überwindet. Des weiteren soll ein Verfahren zur Herstellung solcher Targets angegeben werden.

Das Problem wird für das rohrförmige Target dadurch gelöst; dass der mindestens eine aus dem Zerstäubungsmaterial ragende Teil des Trägerrohres ein Einzelteil ist, das mittels mindestens einer Verschraubung ( von den übrigen Target-Bestandteilen ) lösbar ist.
Eine solche Verschraubung ermöglicht es einerseits, dass ein beschädigter Anschlussbereich eines Trägerrohres ausgewechselt werden kann und der Rest des Trägerrohres weiterhin genutzt werden kann. Andererseits ist es nun möglich, das Trägerrohr vom rohrförmigen Zerstäubungsmaterial durch einfaches herausschrauben zu trennen, ohne dass eine spanende Bearbeitung notwendig wäre.

Um eine gasdichte Verschraubung zwischen einem ersten Raum außerhalb des Targets, welcher gleichbedeutend mit der Vakuumkammer der Kathodenzerstäubungsanlage ist, und einem zweiten Raum innerhalb des Targets, der zur Aufnahme von Kühlmittelleitungen und Magnetvorrichtungen vorgesehen ist, zu erreichen, ist die Verschraubung vorzugsweise mittels einer O-Ring-Dichtung gasdicht ausgebildet, wobei die O-Ring-Dichtung zwischen dem ersten Raum außerhalb des Targets und dem zweiten Raum innerhalb des Targets angeordnet ist.

Eine für das erfindungsgemäße Target geeignete O-Ring-Dichtung kann dabei aus Kunststoff oder weichem Metall gebildet sein, wobei der Querschnitt der O-Ring-Dichtung mit beliebiger Geometrie ausgebildet werden kann. Bevorzugt wird dabei allerdings ein kreisförmiger Querschnitt für die O-Ring-Dichtung.

Insbesondere für bruchanfällige oder weiche Zerstäubungsmaterialien hat es sich bewährt, wenn das Trägerrohr an beiden Enden des Targets aus dem Zerstäubungsmaterial ragt und aus einem ersten, einem zweiten und einem dritten Einzelteil besteht, wobei das erste und das dritte Einzelteil je an einem der beiden Enden des Targets aus dem Zerstäubungsmaterial ragen. Durch eine solche Ausgestaltung ist es möglich, das erste und das dritte Einzelteil in sehr kurzer Länge auszubilden. Dadurch wird die Bearbeitung erleichtert und das Erzeugen beispielsweise einer Spiralnut zum gasdichten Anschluss des ersten und des dritten Einzelteils an die Kathodenzerstäubungsanlage mit hoher Maßgenauigkeit möglich.
Dabei ist vorteilhafterweise das erste Einzelteil mit dem zweiten Einzelteil verschraubt, das zweite Einzelteil mit dem dritten Einzelteil verschraubt und das zweite Einzelteil über seinen Außendurchmesser unlösbar mit dem Innendurchmesser des rohrförmigen Zerstäubungsmaterials verbunden.
Das erste, das zweite und das dritte Einzelteil sind dabei bevorzugt über Feingewinde am Außendurchmesser des ersten Einzelteils, am Innendurchmesser des zweiten Einzelteils und am Außendurchmesser des dritten Einzelteils verschraubt.

Ein Überschneidungsbereich von erstem und zweitem Einzelteil sowie ein Überschneidungsbereich von zweitem und drittem Einzelteil sollte mindestens doppelt so lang sein wie die Länge des jeweiligen Feingewindes zur Verbindung der Einzelteile. Dadurch ergibt sich eine Zentrierung und Führung des ersten und des dritten Einzelteils im zweiten Einzelteil, was sich positiv auf die mechanische Stabilität und Haltbarkeit der Verschraubungen auswirkt. Die Wahl der Länge des Überschneidungsbereiches und des Feingewindes ist jedoch stark vom jeweiligen Zerstäubungsmaterial abhängig und muss für jede Materialkombination und Targetlänge neu festgelegt werden.

Um den zweiten Raum innerhalb des Targets in einfacher Weise mit den Magnetvorrichtungen und der Kühlmittelleitung ausstatten zu können, hat es sich als günstig erwiesen, wenn die Innendurchmesser des ersten, des zweiten und des dritten Einzelteils gleich sind.

Ebenfalls für bruchanfällige oder weiche Zerstäubungsmaterialien hat es sich bewährt, dass das Trägerrohr an einem Ende des Targets aus dem Zerstäubungsmaterial ragt und aus einem ersten und einem zweiten Einzelteil besteht, wobei das erste Einzelteil aus dem Zerstäubungsmaterial ragt.
Dabei ist es von Vorteil, wenn das erste Einzelteil mit dem zweiten Einzelteil verschraubt ist und das zweite Einzelteil über seinen Außendurchmesser unlösbar mit dem Innendurchmesser des rohrförmigen Zerstäubungsmaterials verbunden ist.
Auch hier sollten das erste und das zweite Einzelteil vorzugsweise über Feingewinde am Außendurchmesser des ersten Einzelteils und am Innendurchmesser des zweiten Einzelteils verschraubt sein und ein Überschneidungsbereich von erstem und zweitem Einzelteil mindestens doppelt so lang sein wie die Länge des Feingewindes zur Verbindung der Einzelteile.
Aus den oben genannten Gründen ist es auch hier bevorzugt, wenn die Innendurchmesser des ersten und des zweiten Einzelteils gleich sind.

Für mechanisch stabile Zerstäubungsmaterialien hat es sich bewährt, wenn das Trägerrohr an einem Ende des Targets aus dem Zerstäubungsmaterial ragt und über ein Feingewinde am Innendurchmesser des rohrförmigen Zerstäubungsmaterials und am Außendurchmesser des Trägerrohrs direkt mit dem rohrförmigen Zerstäubungsmaterial verschraubt ist.

Des weiteren ist es für solche Zerstäubungsmaterialien von Vorteil, wenn das Trägerrohr an einem Ende des Targets aus dem Zerstäubungsmaterial ragt und über ein Feingewinde am Außendurchmesser des rohrförmigen Zerstäubungsmaterials und eine Überwurfmutter am Trägerrohr direkt mit dem rohrförmigen Zerstäubungsmaterial verschraubt ist.
Dabei hat es sich insbesondere bewährt, wenn der vom Zerstäubungsmaterial konzentrisch umgebene Längenabschnitt des Trägerrohres mindestens doppelt so lang ist wie die Länge des Feingewindes zur Verbindung von Zerstäubungsmaterial und Trägerrohr.
Eine solche Ausführungsform ermöglicht es, die Länge des Trägerrohrs sehr kurz zu halten. Auch hier ist es vorteilhaft, wenn die Innendurchmesser des Trägerrohrs und des rohrförmigen Zerstäubungsmaterials gleich sind.

Weiterhin ist eine Ausführungsform für mechanisch stabile Zerstäubungsmaterialien vorteilhaft, bei der das Trägerrohr an einem Ende des Targets aus dem Zerstäubungsmaterial ragt und einen Flansch aufweist, der mit einer Stirnfläche des Zerstäubungsmaterials über mindestens zwei Schrauben mit dem rohrförmigen Zerstäubungsmaterial verbunden ist.
Die Innendurchmesser des Trägerrohrs und des rohrförmigen Zerstäubungsmaterials sollten auch hier gleich sein.

Für mechanisch stabile Zerstäubungsmaterialien hat es sich außerdem bewährt, wenn das Trägerrohr aus einem ersten und einem dritten Einzelteil gebildet ist, wobei je ein Einzelteil an je einem der beiden Enden des Targets aus dem Zerstäubungsmaterial ragt und jeweils über ein Feingewinde am Innendurchmesser des rohrförmigen Zerstäubungsmaterials und am Außendurchmesser des jeweiligen Einzelteils direkt mit dem rohrförmigen Zerstäubungsmaterial verschraubt ist.
Ebenso hat es sich als vorteilhaft erwiesen, wenn das Trägerrohr aus einem ersten und einem dritten Einzelteil gebildet ist, wobei je ein Einzelteil an je einem der beiden Enden des Targets aus dem Zerstäubungsmaterial ragt und jeweils über ein Feingewinde am Außendurchmesser des rohrförmigen Zerstäubungsmaterials und eine Überwurfmutter am jeweiligen Einzelteil direkt mit dem rohrförmigen Zerstäubungsmaterial verschraubt ist.
Im Hinblick auf die mechanische Stabilität der Verbindung ist es auch hier von Vorteil, wenn der vom Zerstäubungsmaterial konzentrisch umgebene Längenabschnitt der Einzelteile des Trägerrohres jeweils mindestens doppelt so lang ist wie die Länge des jeweiligen Feingewindes zur Verbindung von Zerstäubungsmaterial und Einzelteil.
Die Innendurchmesser des ersten und des dritten Einzelteils und des rohrförmigen Zerstäubungsmaterials sollten auch hier gleich sein.

Für mechanisch stabile Zerstäubungsmaterialien hat es sich außerdem bewährt, wenn das Trägerrohr aus einem ersten und einem dritten Einzelteil gebildet ist, wobei je ein Einzelteil an je einem der beiden Enden des Targets aus dem Zerstäubungsmaterial ragt und je einen Flansch aufweist, wobei je ein Flansch mit je einer Stirnfläche des Zerstäubungsmaterials über mindestens zwei Schrauben mit dem Zerstäubungsmaterial verbunden ist.
Die Innendurchmesser des ersten und des dritten Einzelteils und des rohrförmigen Zerstäubungsmaterials sollten auch bei dieser Ausführungsform vorteilhafterweise gleich sein.

Als mechanisch stabile Zerstäubungsmaterialien, die auch ohne ein Trägerrohr eingesetzt werden können, das sich über die gesamte Länge des Zerstäubungsmaterials erstreckt, haben sich Metalle wie Ag, Au, Zn, Al, Cu, Nb, Ni, Cr oder eine Legierung aus diesen Elementen erwiesen.

Als bruchanfällige oder weiche Zerstäubungsmaterialien, die in großen Längen nicht ohne ein Trägerrohr über die gesamte Länge des Zerstäubungsmaterials eingesetzt werden können, haben sich Metalle wie Si, Sn, In, Bi oder eine Legierung aus diesen Elementen sowie oxidische Materialien wie ZnO, TiO₂ oder Indiumzinnoxid erwiesen.

Als Material für das Trägerrohr ist Edelstahl aufgrund seiner Festigkeit und Korrosionsbeständigkeit hervorragend geeignet. Es können aber auch andere Materialien mit ähnlichen Eigenschaften für das Trägerrohr verwendet werden.

Das Problem wird für ein Verfahren dadurch gelöst, dass das Trägerrohr aus mehreren Einzelteilen ausgeführt wird, dass mindestens ein aus dem Zerstäubungsmaterial ragendes Einzelteil mit einem Feingewinde versehen wird, dass das mindestens eine aus dem Zerstäubungsmaterial ragende Einzelteil entweder mit einem weiteren Einzelteil des Trägerrohres, das vom Zerstäubungsmaterial konzentrisch umgeben und über seinen Außendurchmesser unlösbar mit dem Innendurchmesser des rohrförmigen Zerstäubungsmaterials verbunden ist, verschraubt wird, oder dass das mindestens eine aus dem Zerstäubungsmaterial ragende Einzelteil über ein Feingewinde am rohrförmigen Zerstäubungsmaterial direkt mit dem rohrförmigen Zerstäubungsmaterial verschraubt wird.

Das Problem wird für ein weiteres Verfahren dadurch gelöst, dass der mindestens eine aus dem Zerstäubungsmaterial ragende Teil des Trägerrohres als ein Einzelteil ausgebildet wird, welches mit einem Flansch versehen wird und dass der Flansch mit einer Stirnfläche des Zerstäubungsmaterials über mindestens zwei Schrauben mit dem rohrförmigen Zerstäubungsmaterial verbunden wird.

Von Vorteil ist es dabei, wenn die Verschraubung mittels einer O-Ring-Dichtung gasdicht ausgebildet wird und wenn die O-Ring-Dichtung zwischen einem ersten Raum außerhalb des Targets ( = Vakuumkammer ) und einem zweiten Raum innerhalb des Targets ( = Raum zur Aufnahme der Kühlmittelleitung und der Magnetvorrichtungen ) angeordnet wird.

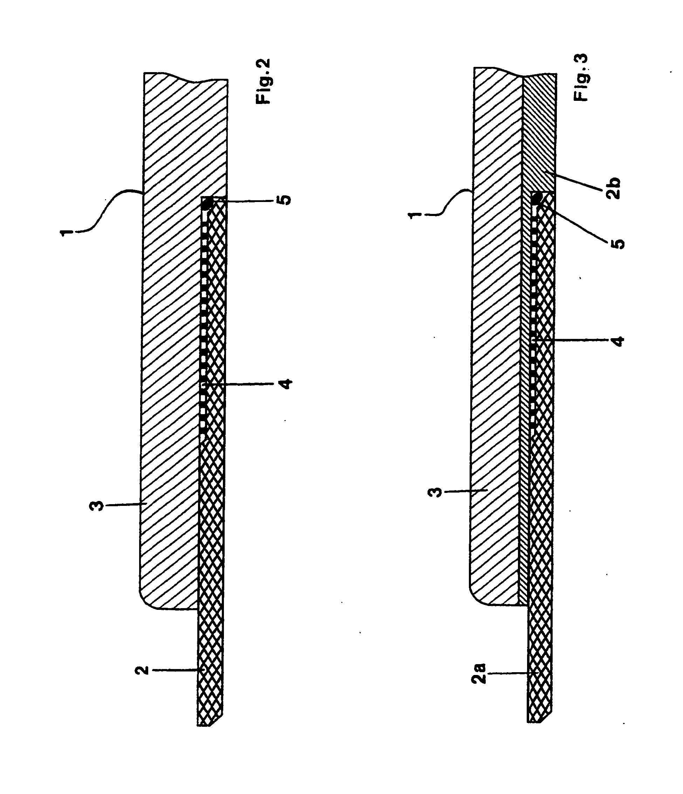

Die Figuren 1 bis 6 und das Beispiel 1 sollen die Erfindung beispielhaft erläutern, wobei Figur 1 eine allgemeine, dreidimensionale Darstellung eines Endes eines rohrförmigen Targets zeigt und die Figuren 2 bis 6 Längsschnitte durch ein solches oder ähnliches Target darstellen, wobei unterschiedliche Verschraubungsarten dargestellt sind. So zeigt
- Fig. 1: einen Anschlussbereich eines rohrförmigen Targets
- Fig. 2: einen Längsschnitt durch ein rohrförmiges Target ( Ansicht nur einer Wandung im Anschlussbereich )
- Fig. 3: einen Längsschnitt durch ein rohrförmiges Target mit über die gesamte Länge des Zerstäubungsmaterials reichendem Trägerrohr ( Ansicht nur einer Wandung im Anschlussbereich)
- Fig. 4: einen Längsschnitt durch ein rohrförmiges Target ( Ansicht nur einer Wandung im Anschlussbereich ) ähnlich Fig. 2
- Fig. 5: einen Längsschnitt durch ein rohrförmiges Target mit Flansch ( Ansicht nur einer Wandung im Anschlussbereich)
- Fig. 6: einen Längsschnitt durch ein rohrförmiges Target mit Überwurfmutter ( Ansicht nur einer Wandung im Anschlussbereich )

Fig. 1 zeigt allgemein den Anschlussbereich an einem Ende eines rohrförmigen Targets 1. Das rohrförmige Target 1 ist aus einem Trägerrohr 2 und einem rohrförmigen Zerstäubungsmaterial 3 gebildet, wobei ein Längenabschnitt des Trägerrohres 2 konzentrisch vom Zerstäubungsmaterial 3 umgeben ist und zum Teil aus diesem herausragt. Die Punktlinie zeigt, wie tief das Trägerrohr 2 in diesem Fall in das Zerstäubungsmaterial 3 reicht. Zum Einbau des rohrförmigen Targets 1 in eine Kathodenzerstäubungsanlage wird der aus dem Zerstäubungsmaterial 3 ragende Teil des Trägerrohres 2 beispielsweise mit einer Spindel verbunden.

Fig. 2 zeigt einen Längsschnitt durch ein rohrförmiges Target 1 gemäß Fig. 1, wobei allerdings nur die Ansicht einer Wandung im rotationssymmetrischen Anschlussbereich dargestellt ist. Das Trägerrohr 2 ist hier direkt mit dem rohrförmigen Zerstäubungsmaterial 3 über eine Verschraubung 4 verbunden, die über ein Außengewinde am Trägerrohr 2 und ein Innengewinde am Zerstäubungsmaterial 3 gebildet ist. Das Trägerrohr 2 und das Zerstäubungsmaterial 3 weisen dabei den gleichen Innendurchmesser auf, so dass am Übergang zwischen dem Trägerrohr 2 und dem Zerstäubungsmaterial 3 im Raum innerhalb des Targets 1 ein flacher Verlauf der Innenkontur entsteht. Eine O-Ring-Dichtung 5 zwischen Trägerrohr 2 und Zerstäubungsmaterial 3 dichtet im Bereich der Verschraubung 4 den Raum außerhalb des Targets 1 gasdicht vom Raum innerhalb des Targets 1 ab. Um die O-Ring-Dichtung 5 genau zu platzieren, ist das Trägerrohr 2 im Kontaktbereich zur O-Ring-Dichtung 5 abgeschrägt. Des weiteren ist das Trägerrohr 2 auch an seinem anderen Ende, das beim Einsatz an die Spindel der Kathodenzerstäubungsanlage angeschlossen wird, im Kontaktbereich zur Spindel angeschrägt, um auch hier eine gasdichte Verbindung gemäß bekannter Anschlusslösungen zu ermöglichen.
Fig. 3 zeigt einen Längsschnitt durch ein rohrförmiges Target 1 mit durchgehendem Trägerrohr 2a; 2b, wobei allerdings nur die Ansicht einer Wandung im rotationssymmetrischen Anschlussbereich dargestellt ist. Das Trägerrohr 2 ist bei der hier dargestellten Lösung aus einem ersten Einzelteil 2a und einem zweiten Einzelteil 2b gebildet, wobei das erste Einzelteil 2a mit dem zweiten Einzelteil 2b über eine Verschraubung 4 verbunden, die über ein Außengewinde am ersten Einzelteil 2a und ein Innengewinde am zweiten Einzelteil 2b gebildet ist. Das zweite Einzelteil 2b ist über seinen äußeren Durchmesser unlösbar, beispielsweise durch Auftrag des Zerstäubungsmaterials 1 auf das zweite Einzelteil 2b über einen Plasmaspritzprozess, mit dem Zerstäubungsmaterial 3 verbunden. Das Trägerrohr 2a; 2b und das Zerstäubungsmaterial 3 weisen dabei den gleichen Innendurchmesser auf, so dass am Übergang zwischen dem Trägerrohr 2a; 2b und dem Zerstäubungsmaterial 3 im Raum innerhalb des Targets 1 ein flacher Verlauf der Innenkontur entsteht. Eine O-Ring-Dichtung 5 zwischen dem ersten Einzelteil 2a und dem zweiten Einzelteil 2b dichtet im Bereich der Verschraubung 4 den Raum außerhalb des Targets 1 gasdicht vom Raum innerhalb des Targets 1 ab. Um die O-Ring-Dichtung 5 genau zu platzieren, ist das erste Einzelteil 2a im Kontaktbereich zur O-Ring-Dichtung 5 abgeschrägt. Des weiteren ist das Trägerrohr 2a; 2b auch an seinem anderen Ende, das beim Einsatz an die Spindel der Kathodenzerstäubungsanlage angeschlossen wird, im Kontaktbereich zur Spindel angeschrägt, um auch hier eine gasdichte Verbindung gemäß bekannter Anschlusslösungen zu ermöglichen.

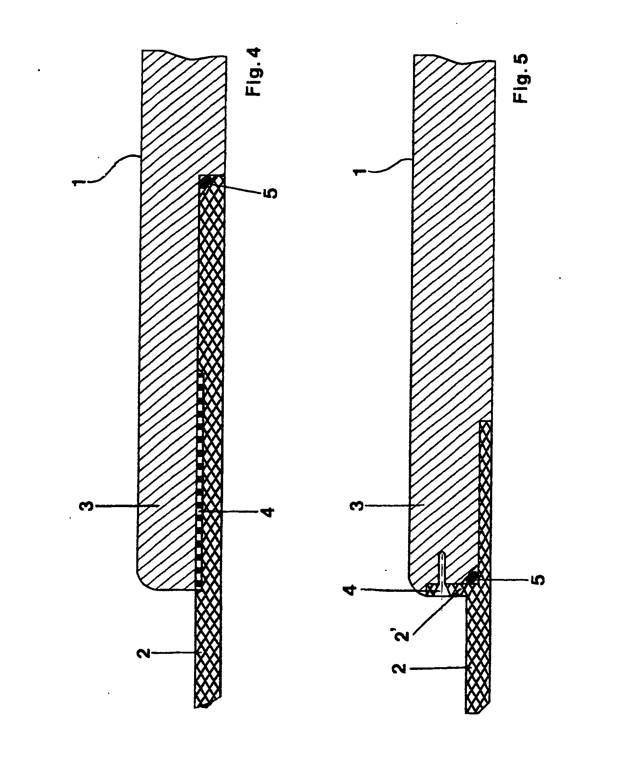

Fig. 4 zeigt eine ähnliche Anordnung wie Fig. 2 mit einen Längsschnitt durch ein rohrförmiges Target 1 gemäß Fig. 1. Das Trägerrohr 2 ist hier wieder direkt mit dem rohrförmigen Zerstäubungsmaterial 3 über eine Verschraubung 4 verbunden, die über ein Außengewinde am Trägerrohr 2 und ein Innengewinde am Zerstäubungsmaterial 3 gebildet ist. Im Unterschied zur Fig. 2 ist in dieser Ausführungsform die Verschraubung 4 weiter entfernt von der O-Ring-Dichtung 5 angeordnet.

Fig. 5 zeigt einen Längsschnitt durch ein rohrförmiges Target 1, wobei nur die Ansicht einer Wandung im rotationssymmetrischen Anschlussbereich dargestellt ist. Das Trägerrohr 2 weist einen Flansch 2' auf, der über eine Verschraubung 4 mit einer Stirnfläche des rohrförmigen Zerstäubungsmaterials 3 verbunden ist. Die Verschraubung 4 ist hier durch einzelne Schrauben gebildet, die direkt in das Zerstäubungsmaterial 3 eingedreht werden. Das Trägerrohr 2 und das Zerstäubungsmaterial 3 weisen dabei den gleichen Innendurchmesser auf, so dass am Übergang zwischen dem Trägerrohr 2 und dem Zerstäubungsmaterial 3 im Raum innerhalb des Targets 1 ein flacher Verlauf der Innenkontur entsteht. Eine O-Ring-Dichtung 5 zwischen Trägerrohr 2 und Zerstäubungsmaterial 3 dichtet im Bereich der Verschraubung 4 den Raum außerhalb des Targets 1 gasdicht vom Raum innerhalb des Targets 1 ab. Um die O-Ring-Dichtung 5 genau zu platzieren, ist das Zerstäubungsmaterial 3 im Kontaktbereich zur O-Ring-Dichtung 5 abgeschrägt. Des weiteren ist das Trägerrohr 2 an dem Ende, das beim Einsatz an die Spindel der Kathodenzerstäubungsanlage angeschlossen wird, im Kontaktbereich zur Spindel angeschrägt, um auch hier eine gasdichte Verbindung gemäß bekannter Anschlusslösungen zu ermöglichen.

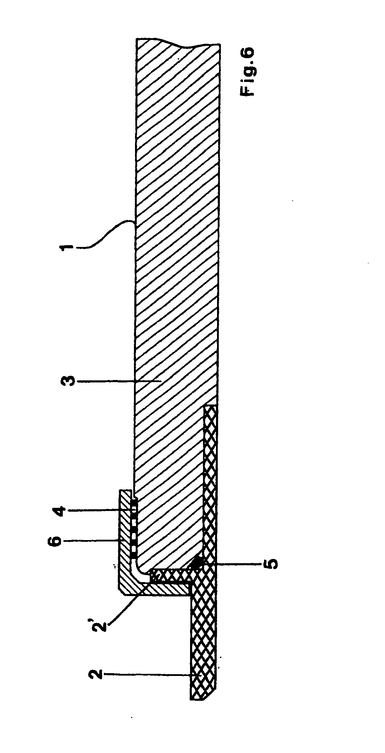

Fig. 6 zeigt einen Längsschnitt durch ein rohrförmiges Target 1 ähnlich Fig. 5, wobei nur die Ansicht einer Wandung im rotationssymmetrischen Anschlussbereich dargestellt ist. Das Trägerrohr 2 weist einen Flansch 2' auf, der über eine Überwurfmutter 6 mit dem rohrförmigen Zerstäubungsmaterial 3 verbunden ist. Die Verschraubung 4 ist hier durch die genannte Überwurfmutter 6 und ein Außengewinde am Zerstäubungsmaterial 3 gebildet. Das Trägerrohr 2 und das Zerstäubungsmaterial 3 weisen dabei den gleichen Innendurchmesser auf, so dass am Übergang zwischen dem Trägerrohr 2 und dem Zerstäubungsmaterial 3 im Raum innerhalb des Targets 1 ein flacher Verlauf der Innenkontur entsteht. Eine O-Ring-Dichtung 5 zwischen Trägerrohr 2 und Zerstäubungsmaterial 3 dichtet im Bereich der Stirnfläche des Zerstäubungsmaterials 3 den Raum außerhalb des Targets 1 gasdicht vom Raum innerhalb des Targets 1 ab. Um die O-Ring-Dichtung 5 genau zu platzieren, ist das Zerstäubungsmaterial 3 im Kontaktbereich zur O-Ring-Dichtung 5 abgeschrägt. Des weiteren ist das Trägerrohr 2 an dem Ende, das beim Einsatz an die Spindel der Kathodenzerstäubungsanlage angeschlossen wird, im Kontaktbereich zur Spindel angeschrägt, um auch hier eine gasdichte Verbindung gemäß bekannter Anschlusslösungen zu ermöglichen.

### Beispiel 1

Ein rohrförmiges Target gemäß den Figuren 1 und 2 wird mit einem Zerstäubungsmaterial 3 aus Silber und einem Trägerrohr 2 aus Edelstahl gebildet, die beide einen Innendurchmesser von 125mm aufweisen. Die Gesamtdicke des Zerstäubungsmaterials 3 beträgt 13,5mm, die des Trägerrohres 2 beträgt 3,75mm. In dem Längenbereich, in dem das Zerstäubungsmaterial 3 das Trägerrohr 2 konzentrisch umgeben soll, wird der Innendurchmesser des rohrförmigen Zerstäubungsmaterials 3 so vergrößert und in einem Teilbereich mit einem Feingewinde versehen, dass das Trägerrohr 2 eingeführt werden kann. Dabei wird die Länge der Vergrößerung des Innendurchmessers so gewählt, dass ein Überschneidungsbereich von Trägerrohr 2 und Zerstäubungsmaterial 3 mit einer Länge von 80mm erzeugt wird. Die Länge des Feingewindes am Innendurchmesser des Zerstäubungsmaterials 3 und am Außendurchmesser des Trägerrohres 2 wird 40mm gewählt. Dadurch, dass die Länge des Überschneidungsbereiches mindestens doppelt so lang gewählt ist wie die Länge des Feingewindes, wird eine Führung und Zentrierung des Trägerrohres 2 im Zerstäubungsmaterial 3 erzeugt. Der Außendurchmesser des Trägerrohrs 2 wird zudem so gewählt, dass ein passgenaues Einschieben in das Zerstäubungsmaterial 3 mit möglichst geringem Spiel möglich ist. Nach Einlegen der O-Ring-Dichtung 5 wird nun das Trägerrohr 2 direkt mit dem Zerstäubungsmaterial 3 gasdicht verschraubt.

## Patentansprüche

1. Rohrförmiges Target für eine Kathodenzerstäubungsanlage mit einem rohrförmigen Zerstäubungsmaterial und einem Trägerrohr, wobei das Zerstäubungsmaterial einen kreisringförmigen Querschnitt aufweist und einen Längenabschnitt des Trägerrohrs konzentrisch umgibt und wobei das Trägerrohr zum Anschluß an die Kathodenzerstäubungsanlage an mindestens einem der beiden Enden des Targets aus dem Zerstäubungsmaterial ragt, **dadurch gekennzeichnet, dass** der mindestens eine aus dem Zerstäubungsmaterial ragende Teil des Trägerrohres ein Einzelteil ist, das mittels mindestens einer Verschraubung lösbar ist.

2. Rohrförmiges Target nach Anspruch 1, **dadurch gekennzeichnet, dass** die Verschraubung mittels einer O-Ring-Dichtung gasdicht ausgebildet ist und dass die O-Ring-Dichtung zwischen einem ersten Raum außerhalb des Targets und einem zweiten Raum innerhalb des Targets angeordnet ist.

3. Rohrförmiges Target nach einem der Ansprüche 1 bis 2, **dadurch gekennzeichnet, dass** das Trägerrohr an beiden Enden des Targets aus dem Zerstäubungsmaterial ragt und aus einem ersten, einem zweiten und einem dritten Einzelteil besteht, wobei das erste und das dritte Einzelteil je an einem der beiden Enden des Targets aus dem Zerstäubungsmaterial ragen.

4. Rohrförmiges Target nach Anspruch 3, **dadurch gekennzeichnet, dass** das erste Einzelteil mit dem zweiten Einzelteil verschraubt ist, dass das zweite Einzelteil mit dem dritten Einzelteil verschraubt und dass das zweite Einzelteil über seinen Außendurchmesser unlösbar mit dem Innendurchmesser des rohrförmigen Zerstäubungsmaterials verbunden ist.

5. Rohrförmiges Target nach Anspruch 4, **dadurch gekennzeichnet, dass** das erste, das zweite und das dritte Einzelteil über Feingewinde am Außendurchmesser des ersten Einzelteils, am Innendurchmesser des zweiten Einzelteils und am Außendurchmesser des dritten Einzelteils verschraubt sind.

6. Rohrförmiges Target nach Anspruch 5, **dadurch gekennzeichnet, dass** ein Überschneidungsbereich von erstem und zweitem Einzelteil sowie ein Überschneidungsbereich von zweitem und drittem Einzelteil mindestens doppelt so lang ist wie die Länge des jeweiligen Feingewindes zur Verbindung der Einzelteile.

7. Rohrförmiges Target nach einem der Ansprüche 3 bis 6, **dadurch gekennzeichnet, dass** die Innendurchmesser des ersten, des zweiten und des dritten Einzelteils gleich sind.

8. Rohrförmiges Target nach einem der Ansprüche 1 bis 2, **dadurch gekennzeichnet, dass** das Trägerrohr an einem Ende des Targets aus dem Zerstäubungsmaterial ragt und aus einem ersten und einem zweiten Einzelteil besteht, wobei das erste Einzelteil aus dem Zerstäubungsmaterial ragt.

9. Rohrförmiges Target nach Anspruch 8, **dadurch gekennzeichnet, dass** das erste Einzelteil mit dem zweiten Einzelteil verschraubt ist und dass das zweite Einzelteil über seinen Außendurchmesser unlösbar mit dem Innendurchmesser des rohrförmigen Zerstäubungsmaterials verbunden ist.

10. Rohrförmiges Target nach Anspruch 9, **dadurch gekennzeichnet, dass** das erste und das zweite Einzelteil über Feingewinde am Außendurchmesser des ersten Einzelteils und am Innendurchmesser des zweiten Einzelteils verschraubt sind.

11. Rohrförmiges Target nach Anspruch 10, **dadurch gekennzeichnet, dass** ein Überschneidungsbereich von erstem und zweitem Einzelteil mindestens doppelt so lang ist wie die Länge des Feingewindes zur Verbindung der Einzelteile.

12. Rohrförmiges Target nach einem der Ansprüche 8 bis 11, **dadurch gekennzeichnet, dass** die Innendurchmesser des ersten und des zweiten Einzelteils gleich sind.

13. Rohrförmiges Target nach einem der Ansprüche 1 bis 2, **dadurch gekennzeichnet, dass** das Trägerrohr an einem Ende des Targets aus dem Zerstäübungsmaterial ragt und über ein Feingewinde am Innendurchmesser des rohrförmigen Zerstäubungsmaterials und am Außendurchmesser des Trägerrohrs direkt mit dem rohrförmigen Zerstäubungsmaterial verschraubt ist.

14. Rohrförmiges Target nach einem der Ansprüche 1 bis 2, **dadurch gekennzeichnet, dass** das Trägerrohr an einem Ende des Targets aus dem Zerstäubungsmaterial ragt und über ein Feingewinde am Außendurchmesser des rohrförmigen Zerstäubungsmateriais und eine überwurfmutter am Trägerrohr direkt mit dem rohrförmigen Zerstäubungsmaterial verschraubt ist.

15. Rohrförmiges Target nach einem der Ansprüche 13 bis 14, **dadurch gekennzeichnet, dass** der vom Zerstäubungsmaterial konzentrisch umgebene Längenabschnitt des Trägerrohres mindestens doppelt so lang ist wie die Länge des Feingewindes zur Verbindung von Zerstäubungsmaterial und Trägerrohr.

16. Rohrförmiges Target nach einem der Ansprüche 13 bis 15, **dadurch gekennzeichnet, dass** die Innendurchmesser des Trägerrohrs und des rohrförmigen Zerstäubungsmaterials gleich sind.

17. Rohrförmiges Target nach einem der Ansprüche 1 bis 2, **dadurch gekennzeichnet, dass** das Trägerrohr an einem Ende des Targets aus dem Zerstäubungsmaterial ragt und einen Flansch aufweist, der mit einer Stirnfläche des Zerstäubungsmaterials über mindestens zwei Schrauben mit dem rohrförmigen Zerstäubungsmaterial verbunden ist.

18. Rohrförmiges Target nach Anspruch 17, **dadurch gekennzeichnet, dass** die Innendurchmesser des Trägerrohrs und des rohrförmigen Zerstäubungsmaterials gleich sind.

19. Rohrförmiges Target nach einem der Ansprüche 1 bis 2, **dadurch gekennzeichnet, dass** das Trägerrohr aus einem ersten und einem dritten Einzelteil gebildet ist, wobei je ein Einzelteil an je einem der beiden Enden des Targets aus dem Zerstäubungsmaterial ragt und jeweils über ein Feingewinde am Innendurchmesser des rohrförmigen Zerstäubungsmaterials und am Außendurchmesser des jeweiligen Einzelteils direkt mit dem rohrförmigen Zerstäubungsmaterial verschraubt ist.

20. Rohrförmiges Target nach einem der Ansprüche 1 bis 2, **dadurch gekennzeichnet, dass** das Trägerrohr aus einem ersten und einem dritten Einzelteil gebildet ist, wobei je ein Einzelteil an je einem der beiden Enden des Targets aus dem Zerstäubungsmaterial ragt und jeweils über ein Feingewinde am Außendurchmesser des rohrförmigen Zerstäubungsmaterials und eine Überwurfmutter am jeweiligen Einzelteil direkt mit dem rohrförmigen Zerstäubungsmaterial verschraubt ist.

21. Rohrförmiges Target nach einem der Ansprüche 19 bis 20, **dadurch gekennzeichnet, dass** der vom Zerstäubungsmaterial konzentrisch umgebene Längenabschnitt der Einzelteile des Trägerrohres jeweils mindestens doppelt so lang ist wie die Länge des jeweiligen Feingewindes zur Verbindung von Zerstäubungsmaterial und Einzelteil.

22. Rohrförmiges Target nach einem der Ansprüche 19 bis 21, **dadurch gekennzeichnet, dass** die Innendurchmesser des ersten und des dritten Einzelteils und des rohrförmigen Zerstäubungsmaterials gleich sind.

23. Rohrförmiges Target nach einem der Ansprüche 1 bis 2, **dadurch gekennzeichnet, dass** das Trägerrohr aus einem ersten und einem dritten Einzelteil gebildet ist, wobei je ein Einzelteil an je einem der beiden Enden des Targets aus dem Zerstäubungsmaterial ragt und je einen Flansch aufweist, wobei je ein Flansch mit je einer Stirnfläche des Zerstäubungsmaterials über mindestens zwei Schrauben mit dem Zerstäubungsmaterial verbunden ist.

24. Rohrförmiges Target nach Anspruch 23, **dadurch gekennzeichnet, dass** die Innendurchmesser des ersten und des dritten Einzelteils und des rohrförmigen Zerstäubungsmaterials gleich sind.

25. Rohrförmiges Target nach einem der Ansprüche 1 bis 24, **dadurch gekennzeichnet, dass** das Zerstäubungsmaterial aus Ag, Au, Zn, Al, Cu, Nb, Ni, Cr oder einer Legierung aus diesen Elementen gebildet ist.

26. Rohrförmiges Target nach einem der Ansprüche 1 bis 12, **dadurch gekennzeichnet, dass** das Zerstäubungsmaterial aus Si, Sn, In, Bi oder einer Legierung aus diesen Elementen gebildet ist oder dass das Zerstäubungsmaterial aus ZnO, TiO₂ oder Indiumzinnoxid gebildet ist.

27. Rohrförmiges Target nach einem der Ansprüche 1 bis 26, **dadurch gekennzeichnet, dass** das Trägerrohr aus Edelstahl gebildet ist.

28. Verfahren zur Herstellung eines rohrförmigen Targets für Kathodenzerstäubungsanlagen nach einem der Ansprüche 1 bis 16 oder 19 bis 22, **dadurch gekennzeichnet, dass** das Trägerrohr aus mehreren Einzelteilen ausgeführt wird, dass mindestens ein aus dem Zerstäubungsmaterial ragendes Einzelteil mit einem Feingewinde versehen wird, dass das mindestens eine aus dem Zerstäubungsmaterial ragende Einzelteil entweder mit einem weiteren Einzelteil des Trägerrohres, das vom Zerstäubungsmaterial konzentrisch umgeben und über seinen Außendurchmesser unlösbar mit dem Innendurchmesser des rohrförmigen Zerstäubungsmaterials verbunden ist, verschraubt wird, oder dass das mindestens eine aus dem Zerstäubungsmaterial ragende Einzelteil über ein Feingewinde am rohrförmigen Zerstäubungsmaterial direkt mit dem rohrförmigen Zerstäubungsmaterial verschraubt wird.

29. Verfahren zur Herstellung eines rohrförmigen Targets für Kathodenzerstäubungsanlagen nach einem der Ansprüche 17 bis 18 oder 23 bis 24 , **dadurch gekennzeichnet, dass** der mindestens eine aus dem Zerstäubungsmaterial ragende Teil des Trägerrohres als ein Einzelteil ausgebildet wird, welches mit einem Flansch versehen wird und dass der Flansch mit einer Stirnfläche des Zerstäubungsmaterials über mindestens zwei Schrauben mit dem rohrförmigen Zerstäubungsmaterial verbunden wird.

30. Verfahren nach einem der Ansprüche 28 bis 29, **dadurch gekennzeichnet, dass** die Verschraubung mittels einer O-Ring-Dichtung gasdicht ausgebildet wird und dass die O-Ring-Dichtung zwischen einem ersten Raum außerhalb des Targets und einem zweiten Raum innerhalb des Targets angeordnet wird.

## Claims

1. Tubular target for a cathode sputtering system with a tubular sputtering material and a carrier tube, wherein the sputtering material has a circular cross section and concentrically surrounds a longitudinal section of the carrier tube and wherein the carrier tube, for connection to the cathode sputtering system, extends on at least one of the two ends of the target from the sputtering material, **characterized in that** the at least one part of the carrier tube extending from the sputtering material is an individual part which can be loosened by means of at least one screw connection.

2. Tubular target according to claim 1, **characterized in that** the screw connection is designed gas tight by means of an O-ring seal and that the O-ring seal is provided between a first space outside the target and a second space inside the target.

3. Tubular target according to any one of the claims 1 to 2, **characterized in that** the carrier tube extends on both ends of the target from the sputtering material and consists of a first, a second and a third individual part, with the first and the third individual part each extending on one of the two ends of the target from the sputtering material.

4. Tubular target according to claim 3, **characterized in that** the first individual part is screwed with the second individual part, that the second individual part is screwed with the third individual part, and that the second individual part, via its outside diameter, is permanently connected with the inside diameter of the tubular sputtering material.

5. Tubular target according to claim 4, **characterized in that** the first, the second, and the third individual part are screwed via fine pitch threads on the outside diameter of the first individual part, on the inside diameter of the second individual part and on the outside diameter of the third individual part.

6. Tubular target according to claim 5, **characterized in that** an overlapping area of first and second individual part, as well as an overlapping area of second and third individual part is at least twice as long as the length of the respective fine pitch thread for the connection of the individual parts.

7. Tubular target according to any one of the claims 3 to 6, **characterized in that** the inside diameters of the first, the second and the third individual part are identical.

8. Tubular target according to any one of the claims 1 to 2, **characterized in that** the carrier tube extends on one end of the target from the sputtering material and consists of a first and a second individual part, with the first individual part extending from the sputtering material.

9. Tubular target according to claim 8, **characterized in that** the first individual part is screwed with the second individual part, and that the second individual part, via its outside diameter, is permanently connected with the inside diameter of the tubular sputtering material.

10. Tubular target according to claim 9, **characterized in that** the first and the second individual part are screwed via fine pitch threads on the outside diameter of the first individual part and on the inside diameter of the second individual part.

11. Tubular target according to claim 10, **characterized in that** an overlapping area of first and second individual part is at least twice as long as the length of the fine pitch thread for the connection of the individual parts.

12. Tubular target according to any one of the claims 8 to 11, **characterized in that** the inside diameters of the first and the second individual part are identical.

13. Tubular target according to any one of the claims 1 to 2, **characterized in that** the carrier tube extends on one end of the target from the sputtering material and is screwed directly with the tubular sputtering material, via a fine pitch thread, on the inside diameter of the tubular sputtering material and on the outside diameter of the carrier tube.

14. Tubular target according to any one of the claims 1 to 2, **characterized in that** the carrier tube extends on one end of the target from the sputtering material and is screwed directly with the tubular sputtering material, via a fine pitch thread, on the outside diameter of the tubular sputtering material and via a cap nut on the carrier tube.

15. Tubular target according to any one of the claims 13 to 14, **characterized in that** the longitudinal section of the carrier tube concentrically surrounded by sputtering material is at least twice as long as the length of the fine pitch thread for the connection of sputtering material and carrier tube.

16. Tubular target according to any one of the claims 13 to 15, **characterized in that** the inside diameters of the carrier tube and of the tubular sputtering material are identical.

17. Tubular target according to any one of the claims 1 to 2, **characterized in that** the carrier tube extends on one end of the target from the sputtering material and comprises a flange which is connected, with one front face of the sputtering material, via at least two screws with the tubular sputtering material.

18. Tubular target according to claim 17, **characterized in that** the inside diameters of the carrier tube and of the tubular sputtering material are identical.

19. Tubular target according to any one of the claims 1 to 2, **characterized in that** the carrier tube is formed of one first and one third individual part, wherein one individual part each extends from the sputtering material on one of the two ends each of the target and is each screwed directly with the tubular sputtering material, via a fine pitch thread, on the inside diameter of the tubular sputtering material and on the outside diameter of the pertinent individual part.

20. Tubular target according to any one of the claims 1 to 2, **characterized in that** the carrier tube is formed of one first and one third individual part, wherein one individual part each extends from the sputtering material on one of the two ends each of the target and is each screwed directly with the tubular sputtering material, via a fine pitch thread, on the outside diameter of the tubular sputtering material and a cap nut on the pertinent individual part.

21. Tubular target according to any one of the claims 19 to 20, **characterized in that** the longitudinal section of the individual parts of the carrier tube concentrically surrounded by sputtering material is at least twice as long as the length of the corresponding fine pitch thread for the connection of sputtering material and individual part.

22. Tubular target according to any one of the claims 19 to 21, **characterized in that** the inside diameters of the first and the third individual part and of the tubular sputtering material are identical.

23. Tubular target according to any one of the claims 1 to 2, **characterized in that** the carrier tube is formed of one first and one third individual part, wherein one individual part each extends from the sputtering material on one of the two ends each of the target and each comprises one flange, one flange each being connected with the sputtering material via at least two screws with one front face each of the sputtering material.

24. Tubular target according to claim 23, **characterized in that** the inside diameters of the first and the third individual part and of the tubular sputtering material are identical.

25. Tubular target according to any one of the claims 1 to 24, **characterized in that** the sputtering material is formed of Ag, Au, Zn, Al, Cu, Nb, Ni, Cr or an alloy of these elements.

26. Tubular target according to any one of the claims 1 to 12, **characterized in that** the sputtering material is formed of Si, Sn, In, Bi or an alloy of these elements, or that the sputtering material is formed of ZnO, TiO₂ or indium tin oxide.

27. Tubular target according to any one of the claims 1 to 26, **characterized in that** the carrier tube is formed of stainless steel.

28. Method for the manufacture of a tubular target for cathode sputtering systems according to any one of the claims 1 to 16 or 19 to 22, **characterized in that** the carrier tube is executed from a plurality of individual parts, that at least one individual part extending from the sputtering material is provided with a fine pitch thread, that the at least one individual part extending from the sputtering material is either screwed with another individual part of the carrier tube which is concentrically surrounded by sputtering material and is permanently connected via its outside diameter with the inside diameter of the tubular sputtering material, or that the at least one individual part extending from the sputtering material is directly screwed with the tubular sputtering material via a fine pitch thread on the tubular sputtering material.

29. Method for the manufacture of a tubular target for cathode sputtering systems according to any one of the claims 17 to 18 or 23 to 24, **characterized in that** the at least one part of the carrier tube extending from the sputtering material is designed as an individual part which is provided with a flange and that the flange is connected with one front face of the sputtering material via at least two screws with the tubular sputtering material.

30. Method according to any one of the claims 28 to 29, **characterized in that** the screw connection is designed gas tight by means of an O-ring seal and that the O-ring seal is provided between a first space outside the target and a second space inside the target.

## Revendications

1. Cible de forme tubulaire pour une installation de pulvérisation cathodique, comprenant un matériau de pulvérisation de forme tubulaire et un tube de support, le matériau de pulvérisation présentant une section transversale en forme d'anneau circulaire et entourant concentriquement un tronçon longitudinal du tube de support, et le tube de support faisant saillie hors du matériau de pulvérisation, à au moins l'une des deux extrémités de la cible, **caractérisée en ce que** ladite au moins une partie du tube de support faisant saillie hors du matériau de pulvérisation est une pièce individuelle qui est démontable ou amovible au moyen d'au moins une liaison vissée.

2. Cible de forme tubulaire selon la revendication 1, **caractérisée en ce que** la liaison vissée est réalisée étanche aux gaz au moyen d'un joint d'étanchéité du type joint torique, et **en ce que** le joint torique d'étanchéité est agencé entre un premier espace à l'extérieur de la cible et un deuxième espace à l'intérieur de la cible.

3. Cible de forme tubulaire selon l'une des revendications 1 à 2, **caractérisée en ce que** le tube de support fait saillie hors du matériau de pulvérisation au niveau des deux extrémités de la cible, et est constitué d'une première, d'une deuxième et d'une troisième pièce individuelle, la première et la troisième pièce individuelle faisant saillie hors du matériau de pulvérisation, chacune respectivement à l'une des deux extrémités de la cible.

4. Cible de forme tubulaire selon la revendication 3, **caractérisée en ce que** la première pièce individuelle est liée par vissage à la deuxième pièce individuelle, **en ce que** la deuxième pièce individuelle est liée par vissage à la troisième pièce individuelle, et **en ce que** la deuxième pièce individuelle est liée de manière inamovible, par l'intermédiaire de son diamètre extérieur, au diamètre intérieur du matériau de pulvérisation de forme tubulaire.

5. Cible de forme tubulaire selon la revendication 4, **caractérisée en ce que** la première, la deuxième et la troisième pièce individuelle sont vissées ensemble par l'intermédiaire de filetages fins sur le diamètre extérieur de la première pièce individuelle, sur le diamètre intérieur de la deuxième pièce individuelle et sur le diamètre extérieur de la troisième pièce individuelle.

6. Cible de forme tubulaire selon la revendication 5, **caractérisée en ce qu'**une zone de chevauchement de la première et de la deuxième pièce individuelle, ainsi qu'une zone de chevauchement de la deuxième et de la troisième pièce individuelle, est d'une longueur au moins égale au double de la longueur du filetage fin respectif pour assurer la liaison des pièces individuelles.

7. Cible de forme tubulaire selon l'une des revendications 3 à 6, **caractérisée en ce que** les diamètres intérieurs de la première, de la deuxième et de la troisième pièce individuelle, sont identiques.

8. Cible de forme tubulaire selon l'une des revendications 1 à 2, **caractérisée en ce que** le tube de support fait saillie hors du matériau de pulvérisation à l'une des extrémités de la cible, et est constitué d'une première et d'une deuxième pièce individuelle, la première pièce individuelle, faisant saillie hors du matériau de pulvérisation.

9. Cible de forme tubulaire selon la revendication 8, **caractérisée en ce que** la première pièce individuelle est liée par vissage à la deuxième pièce individuelle, et **en ce que** la deuxième pièce individuelle est liée de manière inamovible, par l'intermédiaire de son diamètre extérieur, au diamètre intérieur du matériau de pulvérisation de forme tubulaire.

10. Cible de forme tubulaire selon la revendication 9, **caractérisée en ce que** la première et la deuxième pièce individuelle sont vissées ensemble par l'intermédiaire de filetages fins sur le diamètre extérieur de la première pièce individuelle et sur le diamètre intérieur de la deuxième pièce individuelle.

11. Cible de forme tubulaire selon la revendication 10, **caractérisée en ce qu'**une zone de chevauchement de la première et de la deuxième pièce individuelle est d'une longueur au moins égale au double de la longueur du filetage fin pour assurer la liaison des pièces individuelles.

12. Cible de forme tubulaire selon l'une des revendications 8 à 11, **caractérisée en ce que** les diamètres intérieurs de la première et de la deuxième pièce individuelle, sont identiques.

13. Cible de forme tubulaire selon l'une des revendications 1 à 2, **caractérisée en ce que** le tube de support fait saillie hors du matériau de pulvérisation à l'une des extrémités de la cible, et est lié par vissage directement au matériau de pulvérisation de forme tubulaire, par l'intermédiaire d'un filetage fin sur le diamètre intérieur du matériau de pulvérisation de forme tubulaire et sur le diamètre extérieur du tube de support.

14. Cible de forme tubulaire selon l'une des revendications 1 à 2, **caractérisée en ce que** le tube de support fait saillie hors du matériau de pulvérisation à l'une des extrémités de la cible, et est lié par vissage directement au matériau de pulvérisation de forme tubulaire, par l'intermédiaire d'un filetage fin sur le diamètre extérieur du matériau de pulvérisation de forme tubulaire, et d'un écrou d'accouplement sur le tube de support.

15. Cible de forme tubulaire selon l'une des revendications 13 à 14, **caractérisée en ce que** le tronçon longitudinal du tube de support entouré concentriquement par le matériau de pulvérisation, est d'une longueur au moins égale au double de la longueur du filetage fin assurant la liaison du matériau de pulvérisation et du tube de support.

16. Cible de forme tubulaire selon l'une des revendications 13 à 15, **caractérisée en ce que** les diamètres intérieurs du tube de support et du matériau de pulvérisation de forme tubulaire sont identiques.

17. Cible de forme tubulaire selon l'une des revendications 1 à 2, **caractérisée en ce que** le tube de support fait saillie hors du matériau de pulvérisation à l'une des extrémités de la cible, et présente un flasque qui est relié au matériau de pulvérisation de forme tubulaire au niveau d'une surface frontale de bout du matériau de pulvérisation, par l'intermédiaire d'au moins deux vis.

18. Cible de forme tubulaire selon la revendication 17, **caractérisée en ce que** les diamètres intérieurs du tube de support et du matériau de pulvérisation de forme tubulaire sont identiques.

19. Cible de forme tubulaire selon l'une des revendications 1 à 2, **caractérisée en ce que** le tube de support est formé par une première et une troisième pièce individuelle, l'une de chacune des pièces individuelles faisant saillie du matériau de pulvérisation respectivement à l'une des deux extrémités de la cible, et étant liée par vissage directement au matériau de pulvérisation de forme tubulaire, par l'intermédiaire d'un filetage fin sur le diamètre intérieur du matériau de pulvérisation de forme tubulaire et sur le diamètre extérieur de la pièce individuelle respective.

20. Cible de forme tubulaire selon l'une des revendications 1 à 2, **caractérisée en ce que** le tube de support est formé par une première et une troisième pièce individuelle, l'une de chacune des pièces individuelles faisant saillie du matériau de pulvérisation respectivement à l'une des deux extrémités de la cible, et étant liée par vissage directement au matériau de pulvérisation de forme tubulaire, par l'intermédiaire d'un filetage fin sur le diamètre extérieur du matériau de pulvérisation de forme tubulaire et un écrou d'accouplement sur la pièce individuelle respective.

21. Cible de forme tubulaire selon l'une des revendications 19 à 20, **caractérisée en ce que** le tronçon longitudinal des pièces individuelles du tube de support entouré concentriquement par le matériau de pulvérisation, est d'une longueur au moins égale au double de la longueur du filetage fin respectif assurant la liaison du matériau de pulvérisation et de la pièce individuelle.

22. Cible de forme tubulaire selon l'une des revendications 19 à 21, **caractérisée en ce que** les diamètres intérieurs de la première et de la troisième pièce individuelle et du matériau de pulvérisation de forme tubulaire sont identiques.

23. Cible de forme tubulaire selon l'une des revendications 1 à 2, **caractérisée en ce que** le tube de support est formé par une première et une troisième pièce individuelle, l'une de chacune des pièces individuelles faisant saillie du matériau de pulvérisation respectivement à l'une des deux extrémités de la cible, et présentant chacune un flasque, chaque flasque étant relié au matériau de pulvérisation de forme tubulaire au niveau d'une surface frontale de bout respective du matériau de pulvérisation, par l'intermédiaire d'au moins deux vis.

24. Cible de forme tubulaire selon la revendication 23, **caractérisée en ce que** les diamètres intérieurs de la première et de la troisième pièce individuelle et du matériau de pulvérisation de forme tubulaire sont identiques.

25. Cible de forme tubulaire selon l'une des revendications 1 à 24, **caractérisée en ce que** le matériau de pulvérisation est formé de Ag, Au, Zn, Al, Cu, Nb, Ni, Cr ou d'un alliage de ces éléments.

26. Cible de forme tubulaire selon l'une des revendications 1 à 12, **caractérisée en ce que** le matériau de pulvérisation est formé de Si, Sn, In, Bi ou d'un alliage de ces éléments, ou **en ce que** le matériau de pulvérisation est formé par ZnO, TiO₂ ou par un oxyde de zinc et d'indium.

27. Cible de forme tubulaire selon l'une des revendications 1 à 26, **caractérisée en ce que** le tube de support est réalisé en acier spécial ou surfin.

28. Procédé de fabrication d'une cible de forme tubulaire pour des installations de pulvérisation cathodique, selon l'une des revendications 1 à 16 ou 19 à 22, **caractérisé en ce que** l'on réalise le tube de support en plusieurs pièces individuelles, **en ce que** l'on munit d'un filetage fin au moins une pièce individuelle faisant saillie hors du matériau de pulvérisation, **en ce que** l'on assemble par vissage ladite au moins une pièce individuelle faisant saillie hors du matériau de pulvérisation soit avec une autre pièce individuelle du tube de support, qui est entourée concentriquement par le matériau de pulvérisation et est reliée de manière inamovible, par l'intermédiaire de son diamètre extérieur, au diamètre intérieur du matériau de pulvérisation de forme tubulaire, soit **en ce que** l'on assemble par vissage ladite au moins une pièce individuelle faisant saillie hors du matériau de pulvérisation directement avec le matériau de pulvérisation de forme tubulaire, par l'intermédiaire d'un filetage fin sur le matériau de pulvérisation de forme tubulaire.

29. Procédé de fabrication d'une cible de forme tubulaire pour des installations de pulvérisation cathodique, selon l'une des revendications 17 à 18 ou 23 à 24, **caractérisé en ce que** l'on réalise ladite au moins une partie du tube de support, qui fait saillie hors du matériau de pulvérisation, sous la forme d'une pièce individuelle que l'on munit d'un flasque, et **en ce que** l'on assemble le flasque avec le matériau de pulvérisation de forme tubulaire au niveau d'une surface frontale de bout du matériau de pulvérisation, par l'intermédiaire d'au moins deux vis.

30. Procédé selon l'une des revendications 28 à 29, **caractérisé en ce que** l'on rend la liaison vissée étanche aux gaz au moyen d'un joint d'étanchéité du type joint torique, et **en ce que** l'on agence le joint torique d'étanchéité entre un premier espace à l'extérieur de la cible et un deuxième espace à l'intérieur de la cible.
